**Europäisches Patentamt**

**European Patent Office**

**Office européen des brevets**

(19)

(11) **EP 1 160 985 A1**

(12) **EUROPEAN PATENT APPLICATION**

(43) Date of publication:
**05.12.2001 Bulletin 2001/49**

(51) Int Cl.⁷: **H03M 1/18**, **H03M 1/10**

(21) Application number: **00111761.3**

(22) Date of filing: **03.06.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI**<br><br>(71) Applicant: **Telefonaktiebolaget L M Ericsson (Publ)**<br>**126 25 Stockholm (SE)** | (72) Inventor: **André, Tore Mikael**<br>**125 51 Älvsjö (SE)**<br><br>(74) Representative: **Wideberg, Olle Sven**<br>**Ericsson Telecom AB,**<br>**Patent Unit Service and Backbone Networks**<br>**126 25 Stockholm (SE)** |

(54) **Analogue-to-digital converter arrangement**

(57) The invention relates to an analogue-to-digital converter arrangement including an analogue-to-digital converter (23), a variable amplifier (21) connected before the analogue-to-digital converter (23), and a comparation device (22) for comparing a signal with at least one threshold (Th1, Th2, Th3, Th4) and for controlling the amplification in the variable amplifier (21) depending on said comparison. According to the invention said signal is a first analogue signal (A1).

**Fig 3**

EP 1 160 985 A1

## Description

## TECHNICAL FIELD OF THE INVENTION

The present invention relates to an analogue-to-digital converter arrangement and to a receiver including such an analogue-to-digital converter arrangement.

## DESCRIPTION OF RELATED ART

Multi-carrier modulation is a known method for transmitting broadband information (for example, video, Internet or telephony) over radio connections or copper wire. The latter may be e.g. xDSL systems, such as Asymmetric Digital Subscriber Line (ADSL). Two similar methods in multi-carrier modulation are Orthogonal Frequency Division Multiplex (OFDM), used in radio applications, and Discrete Multitone (DMT), which is used in copper wires.

Very briefly explained, the bits that are to be transmitted, of for example a digitally encoded video signal, are encoded as complex numbers in a transmitter. In the transmitter an Inverse Fast Fourier Transform (IFFT) and a digital-to-analogue conversion are carried out whereupon the result is sent out on a line to a receiver.

The IFFT-modulation gives a sum of orthogonal carriers or tones, of which the amplitudes and phase displacements are determined by the values and phases of the complex numbers. These carriers are then transmitted in time slots at constant time intervals and are called symbols. In the receiver an analogue-to-digital conversion and a Fast Fourier Transform (FFT) are carried out instead. In this way, the original bits are retrieved. Attenuation and phase displacement may be easily compensated for, by multiplication by a complex number for each carrier.

Very simplified, analogue-to-digital conversion is performed by first sampling an analogue signal. If the analogue signal has a limited bandwidth, then all information in the analogue signal will be in the sampled signal if the sampling frequency is at least twice the highest frequency of the analogue signal. Then the signal is digitised, i.e. quantised and coded into a digital signal. This gives quantising noise that is dependent on the number of levels that is used for the quantising, i.e. it is dependent on how many bits that are used in the analogue-to-digital converter. The fewer bits that are used, the higher the quantising noise will become. The quantising noise also depends on how well the analogue signal fits into the quantisation interval and on how the probability density of the analogue signal looks. One problem is that the more bits that are used, the higher the manufacturing cost of the analogue-to-digital converter will be and the more power will be consumed.

The analogue signal coming in to an analogue-to-digital converter in a multicarrier system will be Gaussian distributed, i.e. the probability for the signal to have an amplitude near zero is much higher than the probability for a larger amplitude. The problem with this is that the analogue-to-digital converter must be dimensioned for the highest amplitude. This leads to that most of the time only a few bits will be used for the conversion, which is a waste of the expensive bits. An alternative is to clip the highest amplitudes, which introduces clipping errors.

Similar problems also occur in other applications. For certain applications there exists a lot of different versions of automatic gain control (AGC), see e.g. US 3,947,806 or DE 43 19 376. The idea is that a mean value of the digital signal coming out from the analogue-to-digital converter is used to determine amplification of the incoming analogue signal. In GB 2 110 490 the amplification is not changed according to the mean value of the digital signal, but when sufficiently many high or low values are detected.

In all the applications in said patent documents it is not important to restore the initial data, but as e.g. in a TV-camera it is only interesting that there is a range from white to black in the end. However, there are situations, as in the multi-carrier system mentioned above, where it is necessary to be able to restore the data accurately and where thus amplification cannot be made in an arbitrary manner.

Further, even in situations where it is not necessary to be able to restore the data exactly the different automatic gain control versions suffers from another problem, namely that it presupposes an analogue signal with no drastic changes in amplitude. None of the versions can take care of fast changes.

Further, since it is the digital signal that is measured it is impossible to know just how high the analogue signal was before it was clipped in the analogue-to-digital converter.

## SUMMARY

One of the problems with the automatic gain solutions mentioned above is that it is impossible to know how high the analogue signal was before it was clipped in the analogue-to-digital converter. This is not a big problem for the applications in the patent documents mentioned above, because in those applications it is not necessary to be able to recover the data. However, in a system where it is necessary to recover the data, said data is already lost when the analogue-to-digital converter is saturated.

The invention lies partly in discovering that this is a problem in certain applications and is solved in the present invention by reading an analogue signal before the analogue-to-digital converter and comparing it with at least one threshold. This makes it possible to adjust the amplification of the analogue signal before it has entered the analogue-to-digital converter.

An advantage with the present invention is that the analogue-to-digital converter normally never becomes saturated, which means that it is always possible to restore data if that is the wish. Another advantage is that the solution may be used also in systems where it is not necessary to restore data, which thus makes it a more general solution than the earlier existing. Yet another advantage is that since the signal is read before the analogue-to-digital converter it is also possible to take care of fast changes in the analogue signal.

Further advantages may be seen in the different embodiments that now will be described.

## BRIEF DESCRIPTION OF THE DRAWINGS

Fig. 1 shows a block diagram over a known multi-carrier system.

Fig. 2 shows a curve over the probability of occurrence of different amplitudes in an analogue signal entering the analogue-to-digital converter in Fig 1.

Fig. 3 shows a block diagram over an embodiment of the present invention.

Fig. 4 shows a corresponding probability curve as Fig. 2, wherein different values of a first coefficient for amplification are shown between different thresholds for an embodiment of the invention.

Fig. 5 shows a block diagram for the same embodiment as in Fig. 4.

Fig. 6 shows an example of how the invention may be implemented for a second embodiment.

Fig. 7 shows another embodiment of the variable amplifier in Fig 6.

Fig. 8 shows a detailed diagram over how a second coefficient for amplification may be calibrated.

## DETAILED DESCRIPTION OF EMBODIMENTS

As an example the present invention will be described in a multi-carrier modulation system. However, it may of course also be used in other applications.

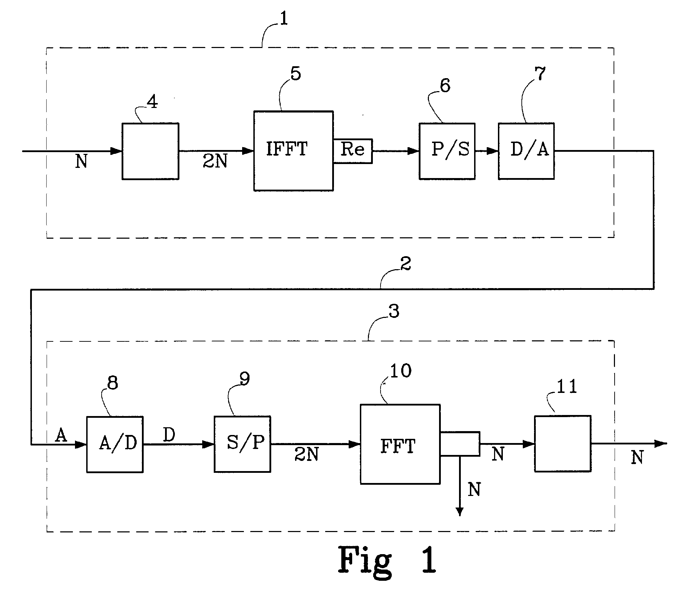

Figure 1 shows, schematically, how the main parts of a prior art system for multi-carrier modulation may look. In a transmitter 1 modulation of data bits, for example from a digitally encoded video signal, is performed.

The bits to be transmitted are encoded in the transmitter 1 as N complex numbers before a hermit symmetry operation is carried out in a calculation block 4. 2N complex numbers are obtained having a symmetric real part and an asymmetric imaginary part.

An Inverse Fast Fourier Transform (IFFT) is then performed in an IFFT calculation unit 5, as a modulation. Since the imaginary part becomes zero it may be eliminated and a real signal remains, which passes a parallel-to-serial converter 6 and a digital-to-analogue converter 7.

This gives a sum of orthogonal carriers or tones, of which the amplitudes and phases are determined by the values and phases of the original complex numbers. These carriers are then transmitted in a line 2 at constant time intervals/time slots and are called symbols.

In a receiver 3 the data, in the opposite way, passes an analogue-to-digital converter 8, a serial-to-parallel converter 9 and an FFT calculation unit 10, in which an FFT is carried out, as a demodulation. This gives 2N complex numbers. For symmetry reasons, for example the upper half of the 2N complex numbers may be discarded, leaving a number N of complex numbers.

Finally, an equalizer 11 is used, which compensates for attenuation and phase displacement by multiplying the different numbers with complex numbers so that finally the same data bits are obtained that were transmitted to begin with.

When an analogue signal A is converted in the analogue-to-digital converter 8 to a digital signal D, a sampling error will occur. The more bits the analogue-to-digital converter 8 uses the more accurate the output will become. However, the more bits that the analogue-to-digital converter 8 uses, the more difficult to manufacture and the more expensive the analogue-to-digital converter 8 will become. Thus, each bit that it is possible to do without in the analogue-to-digital converter 8 is worth a lot.

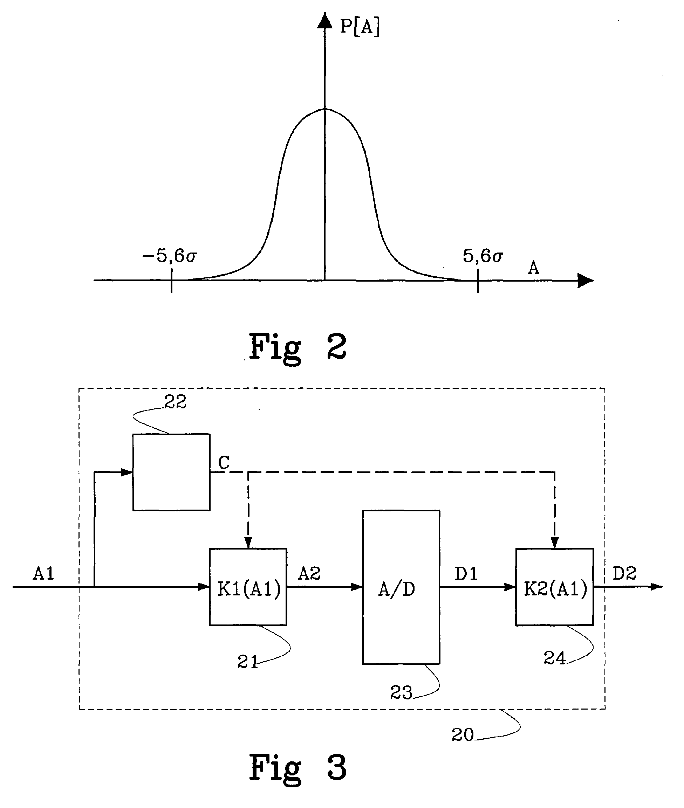

The analogue signal A received at the analogue-to-digital converter 8 is approximately Gaussian distributed, see Fig. 2, i.e. it follows approximately the density function:

$$P(A) = \frac{1}{\sigma\sqrt{2\pi}}\ e^{-(A-m)^2/2\sigma^2} \qquad (2)$$

where the parameter m is a measure on where the peak of the curve is and the parameter $\sigma^2$ is a measure on the signal energy. Both parameters m, $\sigma$ are dependent on the application. In the following examples m=0, that is, the mean value of the curve is placed where the analogue signal A equals zero. In the following examples this will give out a digital signal D equal to zero. This is only to show the reasoning. The skilled man will easily change the following examples to other corresponding equivalent versions.

If the analogue-to-digital converter 8 is dimensioned for the values in the ends of the curve in Fig. 2, i.e. the highest absolute values of the analogue signal A, then most of the time only a few bits will be used for the analogue-to-digital conversion, namely those bits corresponding to the values near zero. This is an obvious waste of bits.

It is therefore common to clip the analogue signal at predetermined values near the ends. If, as an example, a low probability of clipping of $10^{-7}$ is accepted, then the clip level will be at approximately ±5,6$\sigma$. This clipping is made in order to use the range of the analogue-to-digital converter at its optimum. A greater accuracy will be achieved most of the time because more bits are used to sample the values near zero. However, this also means that a clipping error will occur for the peak values.

According to the invention the analogue-to-digital converter 8 is replaced with an analogue-to-digital arrangement 20, see Fig 3. An output of a variable amplifier 21 is connected to an input of an analogue-to-digital converter 23. An output of the analogue-to-digital converter 23 is connected to a digital scaling block 24. Further, a comparation device 22 is connected to the variable amplifier 21 and the digital scaling block 24.

The variable amplifier 21 and the comparation device 22 receive a first analogue signal A1. The comparation device 22 compares the first analogue signal A1 with at least one threshold and sends a control signal C to the variable amplifier 21. In the variable amplifier the first analogue signal A1 is amplified with a variable gain represented by a first variable coefficient K1(A1). Thus a second analogue signal A2 is obtained, which is converted to a first digital signal D1.

The idea is that the first coefficient K1(A1) shall have a different value depending on how close the absolute value of the first analogue signal A1 is to zero. When the first analogue signal A1 is close to zero it can be amplified with a larger first coefficient K1(A1) than if the first analogue signal A1 has a larger absolute value. Thus, the small values of the first analogue signal A1 will be more amplified and thus more bits will be used in the analogue-to-digital converter 23 for said small values and thus the accuracy in the analogue-to-digital conversion will be higher for said small values.

Of course, the highest absolute values of the first analogue signal A1 will be analogue-to-digital converted with a less accuracy, but since the highest absolute values of the first analogue signal A1 occur less frequently, the total error will be reduced compared to e.g. simply clipping as described above. Further, when the analogue-to-digital arrangement 20 is used in a multi-carrier modulation system, then the error will be spread out on all frequencies, since signal detection is made in the frequency domain.

The change of value of the first coefficient K1(A1) should be in the same speed as the sampling made in the analogue-to-digital converter. That is, it should be possible to associate each digital sample D1 coming out from the analogue-to-digital converter 23 with one of the values of the first coefficient K1(A1).

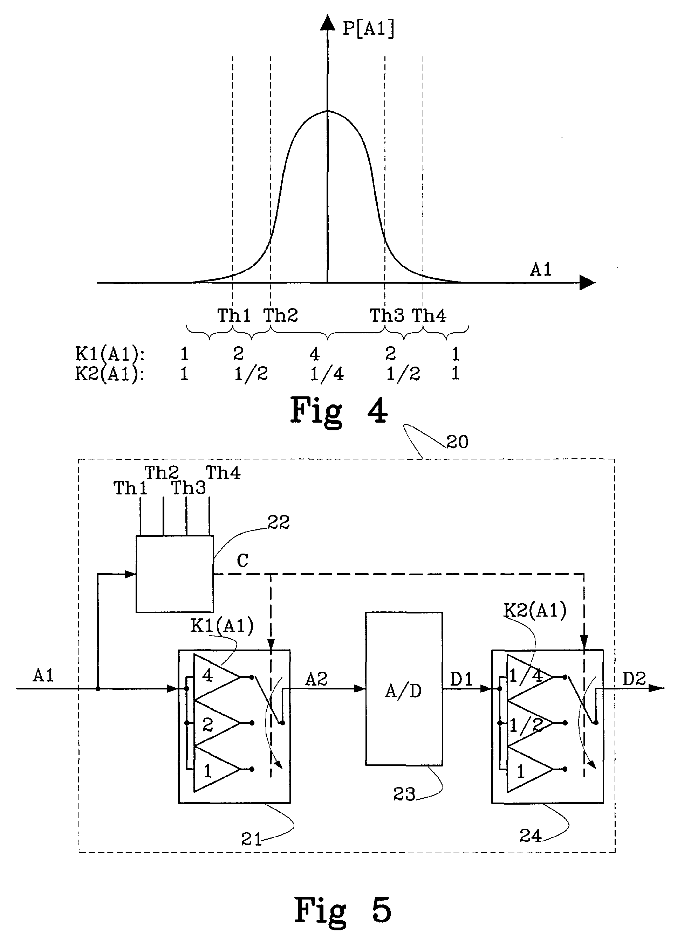

An example where the first coefficient K1(A1) has three different values is shown in Fig 4 and 5. Four thresholds Th1, Th2, Th3, Th4 separate different values of the first analogue signal A1 where different values of the first coefficient K1(A1) are used. In this case Th2 = -Th3 and Th1 = -Th4, but other variants are conceivable. When the first analogue signal A1 has a value near zero the first coefficient K1(A1) is 4. When the first analogue signal A1 has an absolute value further away from zero the first coefficient K1(A1) is 2 and when the first analogue signal A1 has its highest absolute value the first coefficient K1(A1) is 1.

Since one extra bit in the analogue-to-digital converter corresponds to a double range, one alternative is to chose values of the first coefficient K1(A1) so that the values that the first coefficient K1(A1) may assume, may be seen as included in a series of values, where each value is substantially half the preceding value in the series. However, other alternatives are conceivable and depends of how many thresholds that are used and where they are placed.

Thus, if the first analogue signal A1 is very small, another example could be that the values of the first coefficient K1(A1) are 1, ½, ¼, respectively. The number of values for the first coefficient K1(A1) may be two or more. However, there is not much gained by an abundance of values.

In order to restore the data, the comparation device 22 in Fig 3 and 5 also transmits the control signal C to the digital scaling block 24. The digital scaling block 24 then, depending on the value of the control signal C, multiplies the first digital signal D1 with a second coefficient K2(A1) whereupon a second digital signal D2 is obtained.

The second coefficient K2(A1) has values that are complementary to the values of the first coefficient K1(A1), that is for example ¼, ½ and 1, respectively. Thus, what was earlier amplified with 4 is now multiplied with ¼, etc, resulting that all data are equally amplified in total. Thus, the total gain G, which is the product of a chosen value of the second coefficient K2(A1) multiplied with corresponding value of the first coefficient K1(A1), is to be kept substantially constant for all possible values of the first analogue signal A1:

$$G = K2\,(A1) \cdot K1(A1) \approx constant \qquad (3)$$

In order for this to work properly the digital scaling block 24 should preferably receive the control signal C with a little delay corresponding to the delay in the analogue-to-digital converter 23, to ensure that the right samples in the first digital signal D1 are multiplied with the right values of the second coefficient K2(A1).

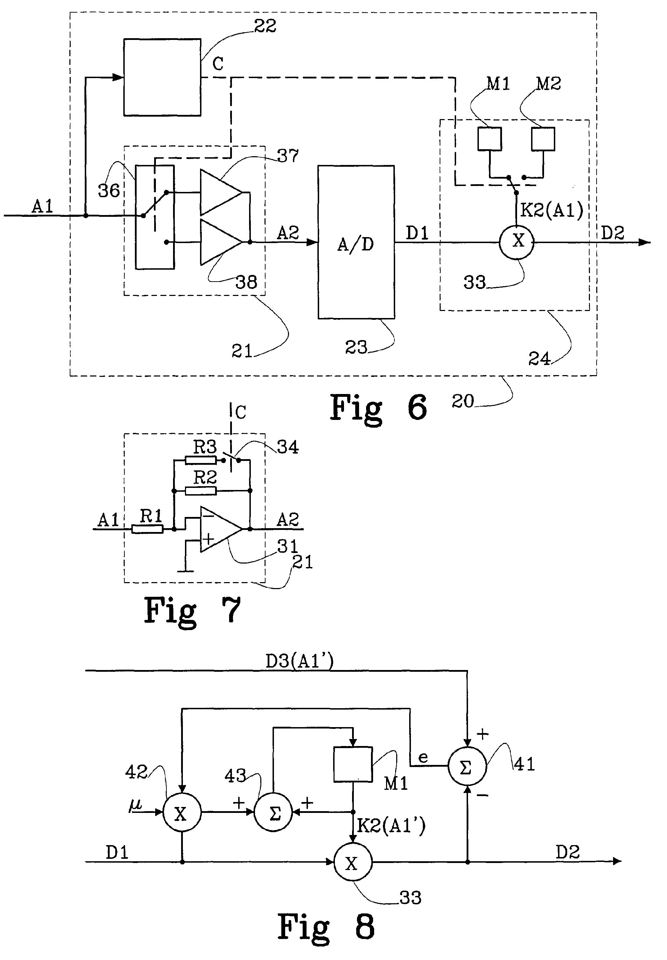

In Fig 6 is shown an example on how the different values of the first coefficient K1(A1) and the second coefficient K2(A1) may be achieved. The example uses two different values of the first coefficient K1(A1) and of the second coefficient K2(A1), but can easily be extended to more values.

The variable amplifier 21, which is analogue, is easiest implemented by using a commercial variable amplifier, such as a voltage-controlled amplifier or a multiplying digital-to-analogue converter. The latter is then used opposite to its normal use, i.e. the digital normal input to the digital-to-analogue converter is used for inputting the first coefficient K1(A1) in a digital format, while the multiplying input is used for inputting the first analogue signal A1.

Another alternative, which is disclosed in Fig 6, is to use an analogue multiplexor 36 that chooses between two or more amplifiers 37, 38 with fixed gain. Yet another alternative is to use an inverting amplifier, which is shown in Fig. 7. An operational amplifier 31 is connected with its positive input to ground or a fixed voltage and with its negative input to a first resistor R1. The other end of the first resistor R1 receives the first analogue signal A1, while the output of the operational amplifier 31 gives out the second analogue signal A2. A second resistor R2 and a third resistor R3 are connected in parallel between the positive input and the output of the operational amplifier 31. The third resistor R3 may be disconnected by a switch 34 or similar, which is controlled by the control signal C. It is also possible to picture using some sort of variable resistor between the positive input and the output of the operational amplifier 31 instead of the second resistor R2 and the third resistor R3.

When the third resistor R3 is disconnected, the second analogue signal A2 will become:

$$A2 = A1 \cdot K1(A1) = - A1 \cdot R2/R1 \qquad (4)$$

When the third resistor R3 is connected, the second analogue signal will become:

$$A2 = A1 \cdot K1(A1) = -A1 \cdot R/R1 \qquad (5a)$$

$$R = R1 \cdot R2/(R1+R2) \qquad (5b)$$

where thus R is the total resistance between the positive input and the output of the operational amplifier 31. The resistors R1, R2, R3 are then selected to achieve the desired values of the first coefficient K1(A1).

The digital scaling block 24 may be implemented by simply having the different values of the second coefficient K2(A1) in different memory positions M1, M2, see Fig. 6. The control signal C tells the digital scaling block 24 which memory position M1, M2 that is to be accessed, whereupon the second coefficient K2(A1) is multiplied with the first digital signal D1, thus giving the second digital signal D2. The multiplication is shown schematically in Fig 6 as 33.

The values of the second coefficient K2(A1) may be calibrated in order to minimise errors resulting from small errors in the values of the first coefficient K1(A1). Such errors may occur e.g. because it is difficult and expensive to manufacture precise resistors and amplifiers. A good algorithm to use is the LMS-algorithm (Least Mean Square). In the basic LMS-algorithm a coefficient K2(A1) is updated according to:

$$K2(A1')_{k+1} = K2(A1')_k + \mu \cdot D1 \cdot e \qquad (6a)$$

$$e = D3(A1') - D2 \qquad (6b)$$

where $\mu$ is a calibration constant, which usually is a small power of 2, and where k = 1, 2, 3... A third digital signal D3(A1') is the digital correspondence to a known first analogue signal A1'. If a known signal is transmitted in the system and thus said known first analogue signal A1' is used it is thus possible to adjust the value of the second coefficient K2(A1') corresponding to said known first analogue signal A1'. The other value(s) of the second coefficient K2(A1) is/are calibrated in a corresponding way, by choosing another known first analogue signal A1" and corresponding third digital signal D3(A1")

The multiplication 42, the addition 43 and the subtraction 41 seen in formulas (6a) and (6b) are shown schematically in Fig. 8 for the calibration of the value of the second coefficient K2(A1) that is stored in the first memory position M1. The calibration of the value of the second coefficient K2(A1) that is stored in the second memory position M2 is performed in the same way, but using another known first analogue signal A1. This may then be extended to any number of memory positions used.

It can be suitable to use a type of sign LMS-algorithm instead of formula (6a), due to the fact that few or no actual multiplications are used in a sign LMS-algorithm. The so-called multiplication will then in practise be performed by simply changing sign. An example of such an algorithm can look like:

$$K2(A1)_{k+1} = K2(A1)_k + \mu \cdot D1 \cdot \text{sign}(e) \qquad (7)$$

Another version of a sign LMS-algorithm can look like:

$$K2(A1)_{k+1} = K2(A1)_k + \mu \cdot e \cdot \text{sign}(D1) \qquad (8)$$

The simplest LMS-algorithm is the sign-sign LMS-algorithm. The second coefficient K2(A1) is then updated according to the formula:

$$K2(A1)_{k+1} = K2(A1)_k + \mu \cdot \text{sign}(D1) \cdot \text{sign}(e) \qquad (9)$$

Note that this adaptation of the second coefficient K2(A1) is not necessary if the accuracy demands are not too high.

This analogue-to-digital converter arrangement is of course also possible to use in other contexts than multi-carrier modulation systems. It works also for first analogue signals that has only positive or only negative values and the first analogue signal need not be Gaussian distributed. However, the invention has its greatest advantages when used in systems where there is a greater probability for the first analogue signal to have a value near zero than to have a greater absolute value.

## Claims

1. Analogue-to-digital converter arrangement including an analogue-to-digital converter (23), a variable amplifier (21) connected before the analogue-to-digital converter (23), and a comparison device (22) for comparing a signal with at least one threshold (Th1, Th2, Th3, Th4) and for controlling the amplification in the variable amplifier (21) depending on said comparison, **characterized in that** said signal is a first analogue signal (A1).

2. Analogue-to-digital converter arrangement according to claim 1, **characterized in that** the comparation device (22) is arranged to read the first analogue signal (A1) with the same speed as analogue-to-digital conversion is made in the analogue-to-digital converter (23).

3. Analogue-to-digital converter arrangement according to claim 1 or 2, **characterized in that** the variable amplifier (21) includes a first coefficient (K1(A1)) that may assume at least two different values, and **in that** the variable amplifier (21) is arranged to amplify the first analogue signal (A1) with a gain corresponding to the value of the first coefficient (K1(A1)).

4. Analogue-to-digital converter arrangement according to claim 3, **characterized in that** the values that the first coefficient (K1(A1)) may assume are included in a series of values, where each value is substantially half the preceding value in the series and where the largest value is to be used when the first analogue signal is close to zero.

5. Analogue-to-digital converter arrangement according to any of the claims 1-4, **characterized in that** the first variable amplifier (21) is a voltage-controlled amplifier.

6. Analogue-to-digital converter arrangement according to any of the claims 1-4, **characterized in that** the first variable amplifier (21) is a multiplying digital-to-analogue converter.

7. Analogue-to-digital converter arrangement according to any of the claims 1-4, **characterized in that** the first variable amplifier (21) includes an analogue multiplexor (36) and at least two amplifiers (37, 38) with fixed gain

8. Analogue-to-digital converter arrangement according to any of the claims 1-4, **characterized in that** the first variable amplifier (21) includes an inverting amplifier.

9. Analogue-to-digital converter arrangement according to any of the claims 1-8, **characterized in that** a digital scaling block (24) is connected after the analogue-to-digital converter (23).

10. Analogue-to-digital converter arrangement according to claim 9, **characterized in that** the analogue-to-digital converter (23) is arranged to give a first digital signal (D1), **in that** the digital scaling block (24) includes a second coefficient (K2(A1)) that may assume at least two different values, and **in that** the digital scaling block (24) is arranged to multiply the second coefficient (K2(A1)) with the first digital signal (D1), thus creating a second digital signal (D2).

11. Analogue-to-digital converter arrangement according to claim 10, **characterized in that** the digital scaling block (24) is arranged to choose the value of the second coefficient (K1(A1)) so that the product (K2(A1)·K1(A1)) of the value of the second coefficient (K2(A1)) multiplied with corresponding value of the first coefficient (K1(A1)) is kept substantially constant for all possible values of the first analogue signal (A1).

12. Analogue-to-digital converter arrangement according to claim 10 or 11, **characterized in that** the digital scaling block (24) includes a calibrator for calibrating the values of the second coefficient.

13. Analogue-to-digital converter arrangement according to claim 12, **characterized in that** the calibrator including a subtracter (41) for comparing a third digital signal (D3(A1)), related to a known first analogue signal (A1), with the second digital signal (D2), thus creating an error signal (e) and further including a multiplier (42) for multiplying a signal related to the error signal (e, sign(e)) with a signal related to the first digital signal (D1, sign(D1)) and with a calibration constant ($\mu$), thus obtaining the value for the second coefficient (K2(A1)) suitable for the known first analogue signal (A1).

14. Receiver in a multi-carrier system including an analogue-to-digital converter arrangement according to any of the claims 1 to 13.

15. Method for converting a first analogue signal (A1) to a first digital signal (D1) wherein the following steps are performed:

    - reading the first analogue signal (A1),

    - comparing the first analogue signal (A1) with at least one threshold (Th1, Th2, Th3, Th4),

- giving a first coefficient (K1(A1)) a value depending on the comparison,

- amplifying the first analogue signal (A1) with a gain corresponding to the value of the first coefficient (K1(A1)), thus obtaining a second analogue signal (A2),

- sampling the second analogue signal (A2) and converting it into a first digital signal (D1).

16. Method according to claim 15, **characterized by** changing the value of the first coefficient (K1(A1)) in the same speed as the sampling is made.

17. Method according to claim 15 or 16, **characterized by**

- giving a second coefficient (K2(A1)) a value

- multiplying the first digital signal (D1) with the value of the second coefficient (K2(A1)), thus obtaining a second digital signal (D2).

18. Method according to claim 17, **characterized by** choosing the value of the second coefficient (K2(A1)) so that the product (K2(A1)·K1(A1)) of the value of the second coefficient (K2(A1)) multiplied with corresponding value of the first coefficient (K1(A1)) is kept substantially constant for all possible values of the first analogue signal (A1).

19. Method according to claim 17 or 18, **characterized by** calibrating the values of the second coefficient (K2(A1)) by

- sending a known first analogue signal (A1),

- comparing a third digital signal (D3(A1)), related to the known first analogue signal (A1), with the second digital signal (D2), thus creating an error signal (e),

- multiplying a signal related to the error signal (e, sign(e)) with a signal related to the first digital signal (D1, sign(D1)) and with a calibration constant ($\mu$), thus obtaining the value for the second coefficient (K2(A1)) corresponding to the known first analogue signal (A1).

Fig 1

Fig 2

Fig 3

Fig 4

Fig 5

Fig 6

Fig 7

Fig 8

**European Patent Office**

**EUROPEAN SEARCH REPORT**

Application Number

EP 00 11 1761

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 343 200 A (MATSUI HISAYOSHI) 30 August 1994 (1994-08-30) * abstract * | 1-11, 14-18 | H03M1/18 H03M1/10 |
| X | US 5 422 643 A (CHU CHING ET AL) 6 June 1995 (1995-06-06) | 1,3,7, 12,15, 17,18 | |
| A | * column 8, line 10 - column 11, line 13 * | 4,11,13, 19 | |
| A | DE 43 22 597 A (GRUNDIG EMV) 19 January 1995 (1995-01-19) * column 4, line 45 - line 65 * | 1-4,7, 9-13, 15-19 | |
| A | US 5 047 772 A (RIBNER DAVID B) 10 September 1991 (1991-09-10) * column 6, line 32 - line 68; figure 4B * | 13,19 | |
| A | US 5 828 328 A (MARKS SCOTT ENSIGN) 27 October 1998 (1998-10-27) * column 3, line 48 - line 56 * | 1,3,4,6, 9-11,15, 17,18 | TECHNICAL FIELDS SEARCHED (Int.Cl.7) H03M |

The present search report has been drawn up for all claims

| Place of search | Date of completion of the search | Examiner |
|---|---|---|
| THE HAGUE | 14 November 2000 | Verhoof, P |

## ANNEX TO THE EUROPEAN SEARCH REPORT
## ON EUROPEAN PATENT APPLICATION NO.

EP 00 11 1761

This annex lists the patent family members relating to the patent documents cited in the above-mentioned European search report.
The members are as contained in the European Patent Office EDP file on
The European Patent Office is in no way liable for these particulars which are merely given for the purpose of information.

14-11-2000

| Patent document cited in search report | | Publication date | Patent family member(s) | | Publication date |
|---|---|---|---|---|---|
| US 5343200 | A | 30-08-1994 | JP | 4267629 A | 24-09-1992 |
| | | | JP | 4111536 A | 13-04-1992 |
| US 5422643 | A | 06-06-1995 | CA | 2115964 A | 25-08-1994 |
| DE 4322597 | A | 19-01-1995 | NONE | | |
| US 5047772 | A | 10-09-1991 | CA | 2042142 A | 05-12-1991 |
| | | | CN | 1057136 A | 18-12-1991 |
| | | | EP | 0460840 A | 11-12-1991 |
| | | | JP | 5083134 A | 02-04-1993 |
| | | | KR | 9405935 B | 24-06-1994 |
| US 5828328 | A | 27-10-1998 | NONE | | |

EPO FORM P0459

For more details about this annex : see Official Journal of the European Patent Office, No. 12/82